# EUROPEAN PATENT SPECIFICATION

(11) **EP 0 517 353 B1**
(45) Date of publication and mention of the grant of the patent: **14.05.1997**
(21) Application number: 92302353.5
(22) Date of filing: 19.03.1992
(51) Int. Cl.: H01L 29/788, H01L 27/115, H01L 21/28, G11C 16/04

(54) **Non-volatile memory**
Nichtflüchtiger Speicher
Mémoire rémanente

(30) Priority: 07.06.1991 JP 136800/91; 30.07.1991 JP 214532/91
(43) Date of publication of application: 09.12.1992
(73) Proprietor: SHARP KABUSHIKI KAISHA, Osaka 545 (JP)
(72) Inventor: Yamauchi, Yoshimitsu, Yamatokoriyama-shi, Nara-ken (JP)
(74) Representative: Brown, Kenneth Richard

(56) References cited:
- EP-A- 0 193 841
- EP-A- 0 335 395
- EP-A- 0 389 721
- EP-A- 0 411 573
- WO-A-89/06429
- DE-A- 3 736 387
- US-A- 4 794 565
- PATENT ABSTRACTS OF JAPAN vol. 11, no. 227 (E-526) 23 July 1987; & JP-A-62 043 179
- PATENT ABSTRACTS OF JAPAN vol. 13, no. 2 (E-700) 6 January 1989; & JP-A-63 215 079

## Description

### BACKGROUND OF THE INVENTION

### 1. Field of the Invention

The present invention relates to a non-volatile memory with high integration, and more particularly to a source - side injection of hot electron type FLASH EEPROM in which writing can be performed at a single supply voltage of 5 V or less.

### 2. Description of the Prior Art

Conventionally, there has been provided a FLASH EEPROM in which writing is performed by channel hot electron injection from the drain side of a single transistor. Consequently, a writing current of about 1 mA is needed. In addition, a writing efficiency is low so that it is necessary to apply a high voltage more than 5 V to a drain. Accordingly, it is difficult to generate an on-chip high voltage. Therefore, there is needed an extra external supply of higher voltage than a normal 5 V supply voltage.

JP-A-62-43179 discloses a non-volatile memory comprising a p-type semiconductor substrate on which are formed, as a first wiring layer, a transfer gate and a floating gate disposed at the side wall on one side of the transfer gate, and, as a second wiring layer, a control gate which covers the floating gate. An n-type low-concentration diffused layer is formed in the substrate beneath the floating gate. An n-type high concentration diffused layer is provided in the substrate outside of the transfer gate and the control gate.

US-A-4 794 565 discloses an electrically programmable and erasable memory element using source-side hot-electron injection, having a floating gate disposed over a channel region of the element and a control gate disposed over the floating gate. A polysilicon spacer formed to the side of the floating gate and the control gate is used as a mask during ion implantation of the source, whereby a weak gate control region is provided near the source. This enables a relatively high channel electric field for promoting hot electron injection to be created under the weak gate control region when the element is biased for programming.

### SUMMARY OF THE INVENTION

It is an object of the present invention to provide a non-volatile memory in which the wiring efficiency is enhanced so that the writing can be performed at a single supply voltage of 5 V or less and at a speed of 1 µs or less, whereby a single power source is sufficient. Alternatively, the present invention cell makes it possible to realize a reduction in the area of a memory cell.

The present invention, as defined by claim 1, provides a non-volatile memory having a memory cell, the memory cell comprising:
a semiconductor substrate having first and second impurity diffusion layers;
a first insulating film provided on the semiconductor substrate between the first and second impurity diffusion layers and on the first impurity diffusion layer side;
a first electrode formed on the first insulating film, and self-aligned with the first impurity diffusion layer; and
a second electrode;
characterized by:
a tunnel dielectric film extended from the first insulating film to the second impurity diffusion layer region which is provided opposite the first impurity diffusion layer side;
a floating gate formed on the tunnel dielectric film as a side wall spacer on the side wall of the first electrode through an insulating film, and self-aligned with the second impurity diffusion layer; and
said second electrode being provided at least on the floating gate through a second insulating film so as to control the potential of the floating gate;
whereby channel hot electrons can be injected from the inversion layer formed under the first electrode, which is controlled by the first electrode, to the floating gate.

The preamble of claim 1 reflects the state of the art according to US-A-4 794 565.

The sub-claims 2 to 16 are directed to embodiments of the invention.

### BRIEF DESCRIPTION OF THE DRAWINGS

Figure 1 is a view for explaining the structure of a memory cell according to the present invention;
Figure 2 is an equivalent circuit diagram showing the memory cell;
Figure 3 is a view for explaining steps of manufacturing the memory cell;
Figure 4 is a characteristic chart showing the relationship between an auxiliary gate voltage (Vag) and a threshold voltage (Vth) during programming and erasing of the memory cell;
Figure 5 is a characteristic chart showing the relationship between a threshold voltage (Vt) and a program time during the programming of the memory cell;
Figure 6 is an equivalent circuit diagram showing a memory cell array according to a first embodiment of the present invention;
Figure 7 is a view for explaining a structure according to the first embodiment of the present invention;
Figure 8 is a view for explaining manufacturing steps according to the first embodiment of the present invention;
Figure 9 is an equivalent circuit diagram showing a memory cell array according to a second embodiment of the present invention;
Figure 10 is a view for explaining a structure according to the second embodiment of the present invention;
Figure 11 is a view for explaining manufacturing steps according to the second embodiment of the present invention;
Figure 12 is an equivalent circuit diagram showing a memory cell array according to a third embodiment of the present invention;
Figure 13 is a view for explaining manufacturing steps according to the third embodiment of the present invention;
Figure 14 is an equivalent circuit diagram showing a memory cell array according to fourth and fifth embodiments of the present invention;
Figure 16 is a view showing the memory cell array according to the fourth and fifth embodiments of the present invention;
Figure 17 is a view showing the memory cell array according to the fourth and fifth embodiments of the present invention;
Figure 18 is a view for explaining manufacturing steps according to the fifth embodiment of the present invention; and
Figure 19 is a view for explaining manufacturing steps according to the fourth embodiment of the present invention.

### DETAILED DESCRIPTION OF PREFERRED EMBODIMENTS

The present invention provides a FLASH EEPROM comprising a first electrode formed on a first insulating film, and a second electrode for at least covering a floating gate to be controlled, the floating gate being obtained by forming polysilicon side wall spacers on a tunnel dielectric film so as to be self-aligned with the first electrode, so that channel hot electrons can be injected from the inversion layer formed under the first electrode, which is controlled by the first electrode, to the floating gate.

A first impurity diffusion layer of a memory cell according to the present invention is a source region.

A second impurity diffusion layer of the memory cell according to the present invention is a drain region.

The first insulating film according to the present invention is a gate oxide film of the first electrode, for example, a SiO₂ film and has a thickness of about 50 to 200 Å.

The tunnel dielectric film is extended to a second impurity diffusion layer region which is provided opposite the first impurity diffusion layer.

The tunnel dielectric film according to the present invention is a tunnel insulating film provided under the floating gate, for example, a SiO₂ film and has a thickness of about 20 to 100 Å.

Preferred embodiments of the present invention will be described below. The present invention is not limited to the following embodiments.

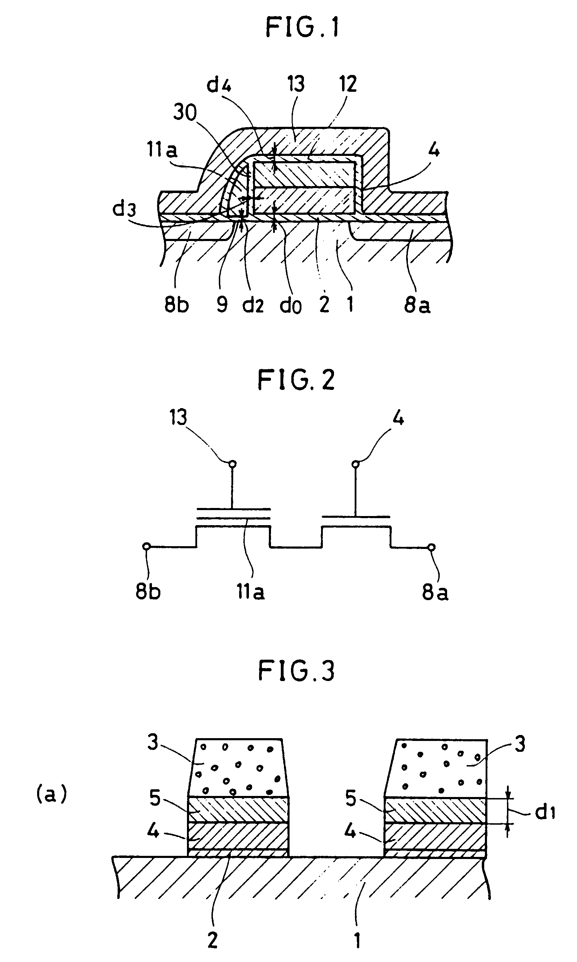

Fig. 1 shows a memory cell of a non-volatile memory according to an embodiment of the present invention.

In Fig. 1, the non-volatile memory comprises a p-type Si substrate 1 having an n⁺ diffusion layer 8a as a source and an n⁺ diffusion layer 8b as a drain, a first insulating film as a SiO₂ gate oxide film 2, a tunnel dielectric film as a SiO₂ tunnel insulating film 9, a first electrode as an auxiliary gate (AG) 4, a floating gate 11a, and a second electrode as a control gate (CG) 13. The first insulating film 2 is provided between the source 8a and the drain 8b, and has a thickness d0 of 170 Å. The tunnel dielectric film 9 is extended to the drain 8b which is provided opposite the source 8a, and has a thickness d2 of 80 Å. The AG 4 is formed on the first insulating film 2 for injecting hot electrons from the source-side of the floating gate so as to perform writing. The floating gate 11a is formed on the tunnel dielectric film 9 and on the side wall of the first electrode 4 through an insulating film (which has a thickness d3 of 500 Å) 30. The CG 13 is provided at least on the floating gate 11a through a SiO₂ film (second insulating film) 12 having a thickness d4 of 200 Å so as to control the potential of the floating gate 11a.

A manufacturing method will be described below.

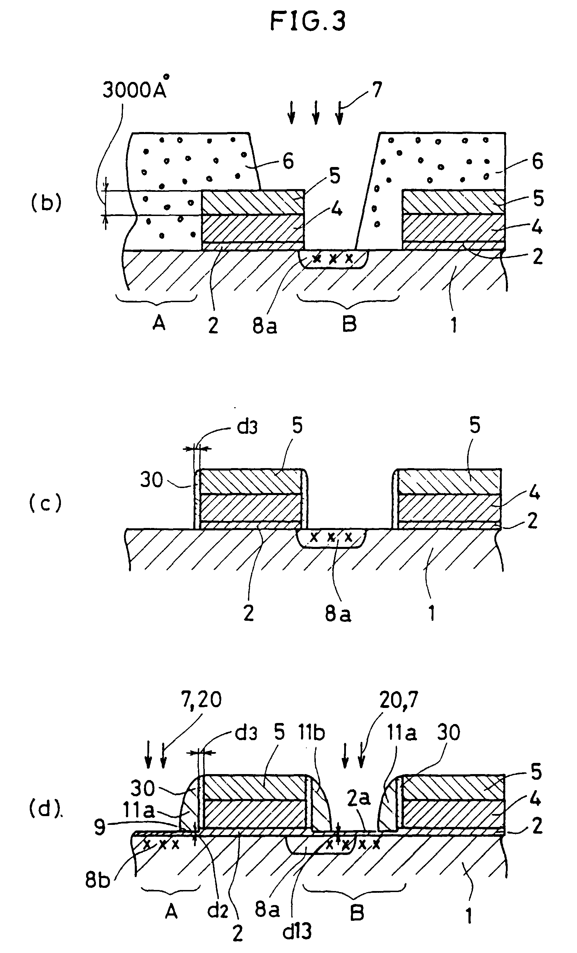

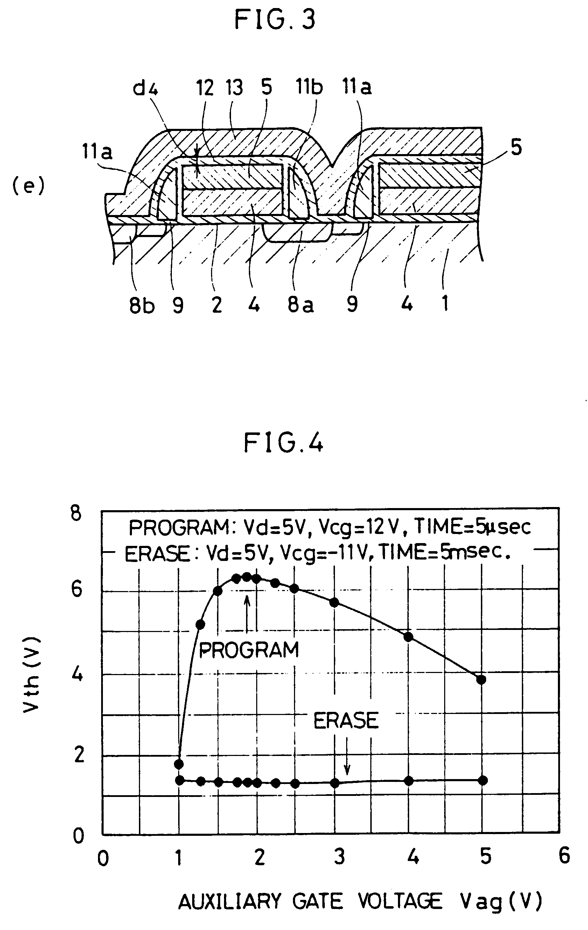

As shown in Fig. 3 (a), a SiO₂ gate oxide film 2 having a thickness of 170 Å is formed as a first insulating film on a p-type Si substrate 1 by thermal oxidation. Then, a polysilicon layer having a thickness of 3000 Å and a SiO₂ film having a thickness d1 of 1500 Å are sequentially laminated on the whole surface of the gate oxide film 2. Thereafter, a resist pattern 3 is laminated at a thickness of, for example, 1 µm. Subsequently, etching is carried out to form an auxiliary gate (AG) 4 and a SiO₂ film 5 [see Fig. 3 (a)].

After the resist pattern 3 is removed, an ion implantation mask 6 is formed. Then, As ions 7 are implanted by using the ion implantation mask 6 and AG 4 as masks [see Fig. 3 (b)]. Consequently, an n⁺ diffusion layer 8a as a source is formed on one B of two n⁺ diffusion layer formation regions A, B of the AG 4. In this case, a quantity of ion implantation is 1 x 10¹⁵ cm⁻² at an accelerating voltage of 80 KeV.

After the mask 6 is removed, a SiO₂ insulating film having a thickness of 500 Å (not shown) is laminated on the whole surface of the Si substrate 1 having the AG 4. Then, SiO₂ side wall insulating films 30 having a thickness d3 of 500 Å are formed on the side walls of the AG 4 by etchback [see Fig. 3 (c)]. The side wall insulating film 30 may be a two-layer film such as a SiO₂/SiN film, or a three-layer film such as a SiO₂/SiN/SiO₂ film (ONO film).

Then, thermal oxidation is carried out to form a tunnel dielectric film as a SiO₂ tunnel insulating film 9 having a thickness d2 of 80 Å in a region A and a SiO₂ film 2a having a thickness d13 of 150 Å in a region B in accordance with the difference between oxide film forming speeds corresponding to the difference between impurity densities on the Si substrate 1 in the regions A and B [see Fig. 3 (d)]. Then, a polysilicon layer having a thickness of 4000 Å is laminated on the whole surface of the Si substrate 1 having the side wall insulating films 30. Then, etchback is carried out by normal Reactive Ion Etching (RIE) so as to form polysilicon side wall spacers 11a and 11b on the side walls of the AG 4 [see Fig. 3 (d)].

In this case, the side wall 11a is provided on the n⁺ diffusion layer side (drain 8b to be formed in a next step) opposite to the n⁺ diffusion layer 8a of the AG 4. In addition, the side wall 11a is formed on the SiO₂ tunnel insulating film 9 having a thickness of 80 Å and functions as a floating gate (FG). On the other hand, the side wall 11b is not related to the operation of the memory cell. Accordingly, the side wall 11b may be removed by RIE.

Then, As ions 7 and P ions 20 are implanted in the Si substrate 1 again so as to form the n⁺ diffusion layer 8b as a drain in the residual n⁺ diffusion layer formation region A [see Fig. 3 (d)]. In this case, quantities of the As and P ions to be implanted are 5 x 10¹⁴ cm⁻² and 2 x 10¹⁴ cm⁻², respectively.

Subsequently, a SiO₂ film 12 having a thickness d4 of 200 Å is formed on the whole surface of the Si substrate 1 having the source 8a, drain 8b and side wall insulating films 30. Then, a polysilicon layer having a thickness of 2000 Å is laminated on the SiO₂ film 12. Thereafter, etching is carried out by using a resist mask (not shown) so as to form a control gate (CG) 13 [see Fig. 3 (e)].

Fig. 2 shows an equivalent circuit of the memory cell according to the present embodiment.

In the equivalent circuit shown in Fig. 2, voltages to be applied to the source 8a, drain 8b, AG 4 and CG 13 are represented by Vs, Vd, Vag and Vcg, respectively. By way of example, if the voltages shown in Table 1 are applied, the memory cell can be operated.

**Table 1**

| | Vs | Vd | Vcg | Vag |
|---|---|---|---|---|
| WRITE | 0 | 5 V | 12 V | 2 V |
| ERASE | 0 | 5 V | -11 V | 0 |
| READ | 0 | 2 V | 5 V | 5 V |

In Table 1, a high voltage is applied to the CG 13 so that a portion just under the FG 11a is held in the state of strength inversion at the time of writing. When a voltage of about Vth is applied to the AG 4, hot electrons are injected from a source-side of the floating gate to the FG 11a.

At the time of erasing, the electrons are pulled out by an F/N tunnel current flowing from the FG 11a to the drain 8b.

Fig. 4 shows a threshold voltage Vth of the programmed memory cell as a function of an AG voltage Vag.

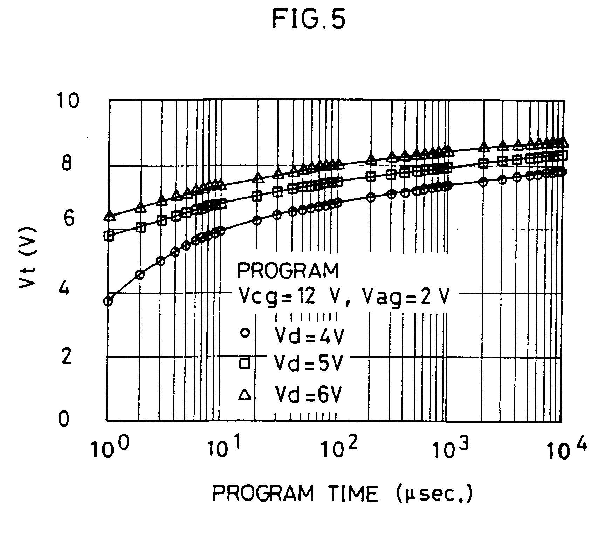

Fig. 5 shows a threshold shift of the programmed memory cell as a function of programming time for different voltages.

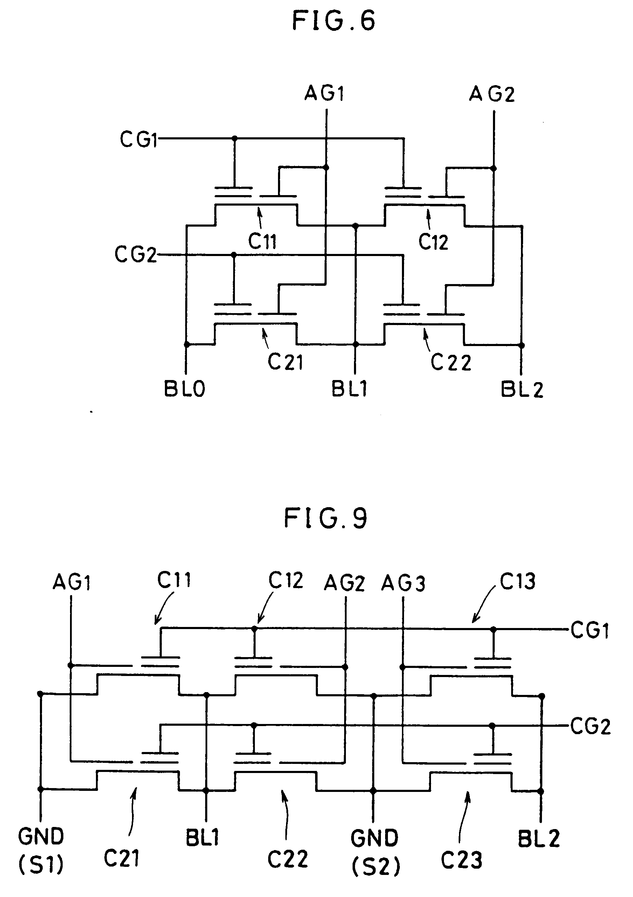

Fig. 6 shows a memory cell array according to a first embodiment of the present invention in which a plurality of memory cells are arranged. The memory cells are provided in one direction such that source and drain regions of the respective adjacent memory cells are continuously formed. AGs are continuously formed in the direction orthogonal to the above-mentioned one direction of memory cells. The source and drain regions are connected to one another in parallel with the direction in which the AGs are connected to one another.

In Fig. 6, the source and drain of adjacent memory cells C11 and C12 are connected to each other.

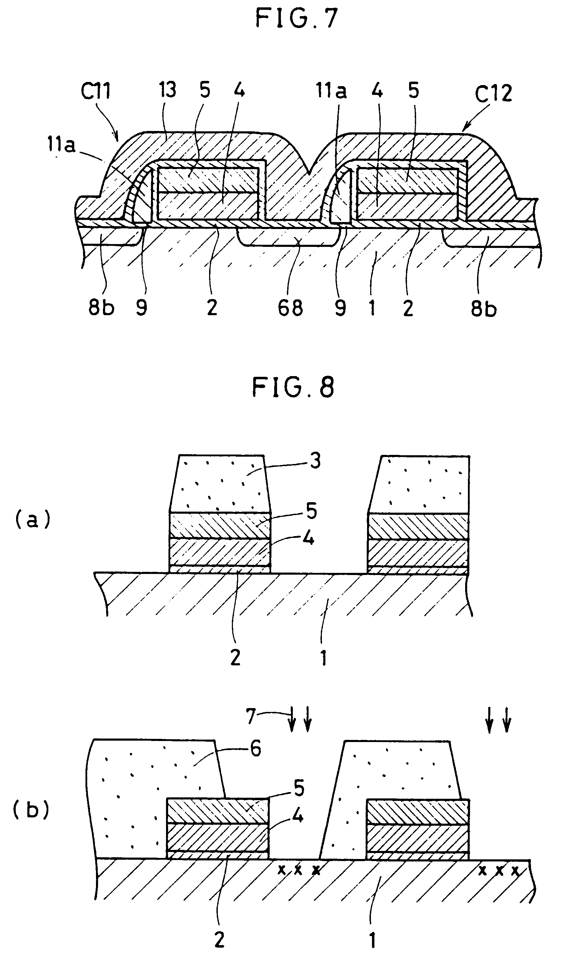

Fig. 7 shows the schematic structure of the memory cells C11 and C12 in Fig. 6. As shown in Fig. 7, a floating gate of a first electrode of the memory cell C12 is provided adjacently to the side having no floating gate of the first electrode of the memory cell C11. An impurity diffusion layer 68 is formed between the memory cells C11 and C12. The impurity diffusion layer 68 functions as a source for the memory cell C11 and as a drain for the memory cell C12.

A manufacturing method will be described below.

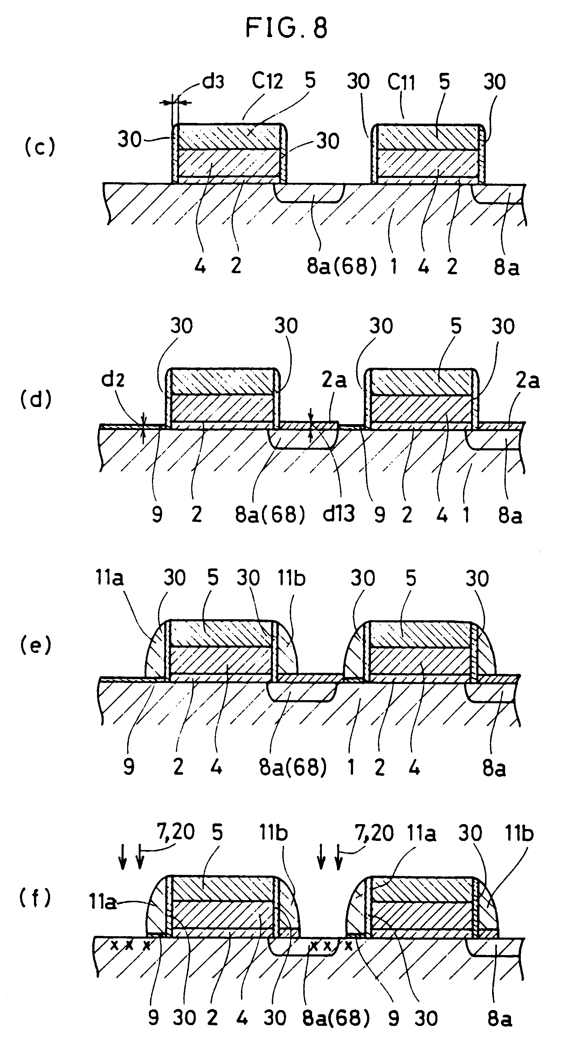

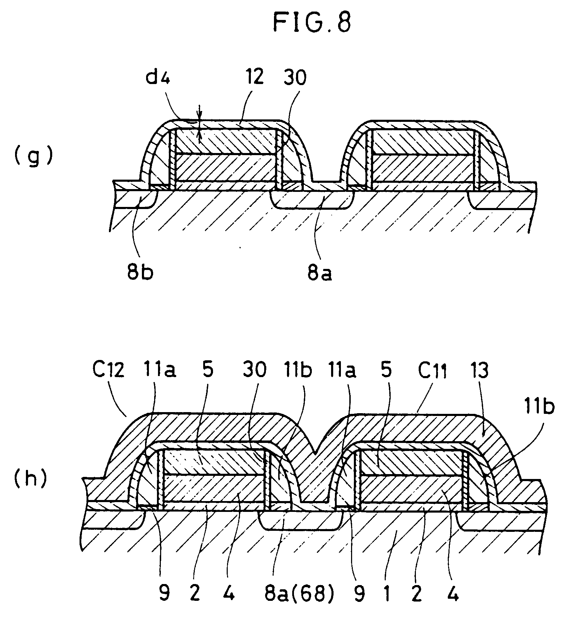

As shown in Fig. 8 (a), a first insulating film 2, an AG 4 and a SiO₂ film 5 are formed on a p-type Si substrate 1 by using a resist pattern 3 [the same step as in Fig. 3 (a)].

As shown in Fig. 8 (b), the resist pattern 3 is removed and a mask 6 is formed. Then, As ions 7 are implanted in a source region [the same step as in Fig. 3 (b)].

As shown in Fig. 8 (c), the mask 6 is removed to laminate a SiO₂ film on the whole surface. Then, etchback is carried out to form side wall insulating films 30 [the same step as in Fig. 3 (c)].

As shown in Fig. 8 (d), thermal oxidation is carried out to form a SiO₂ film 9 having a thickness d2 of 80 Å and a SiO₂ film 2a having a thickness d13 of 150 Å. As shown in Fig. 8 (e), a polysilicon layer having a thickness of 4000 Å is laminated on the whole surface. Then, etchback is carried out to form polysilicon side wall spacers 11a and 11b on the side walls of the AG 4. The side wall spacer 11a is used for a floating gate. As shown in Fig. 8 (f), As ions 7 and P ions 20 are implanted in a drain region on the Si substrate 1. In this case, there may be removed the unnecessary side wall spacer 11b which is formed in Fig. 8 (e). Fig. 7 shows an embodiment in which the side wall spacer 11b is removed. The side wall spacer 11b may be removed before or after the As and P ions are implanted.

The steps shown in Figs. 8 (d) to (f) are the same as in Fig. 3 (d).

As shown in Fig. 8 (g), a SiO₂ film 12 having a thickness d4 of 200 Å is formed on the whole surface. Then, a polysilicon layer having a thickness of 2000 Å is laminated on the SiO₂ film 12 so as to pattern a CG 13 as shown in Fig. 8 (h). The steps shown in Figs. 8 (g) to (h) are the same as in Figs. 3 (e).

As shown in Fig. 6, the first embodiment provides a memory cell array in which the source and drain of the adjacent memory cells C11 and C12 and the memory cells C21 and C22 are continuously formed, and the memory cells C11 and C21 and the memory cells C12 and C22 are respectively connected to each other by embedded diffusion layers. AG 1 is connected to the memory cells C11 and C21, while AG 2 is connected to the memory cells C12 and C22. CG1 is connected to the memory cells C11 and C12, while CG2 is connected to the memory cells C21 and C22. As a result, it is not necessary to form a contact region for connecting the impurity diffusion layers as the source and drain and a wiring layer such as a metal or the like. Consequently, the area of the memory cell array can be reduced so that the high integration of an element can be obtained.

According to the first embodiment, the sources and drains of the adjacent memory cells are continuously connected to one another. The sources of the adjacent memory cells can continuously be connected to one another. In addition, the drains of the adjacent memory cells can continuously be connected to one another.

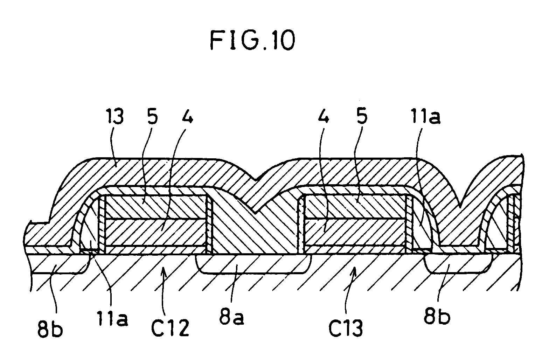

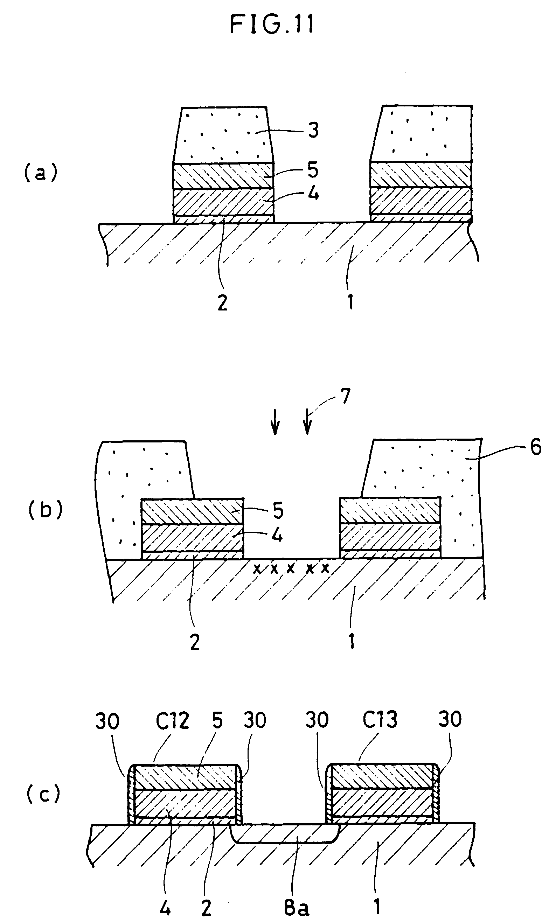

Fig. 9 shows a memory cell array according to a second embodiment of the present invention in which a plurality of memory cells are arranged. The memory cells C11, C12, C13, ... are provided in one direction such that source regions of the adjacent memory cells C12 and C13 are continuously formed and the drain regions of adjacent memory cells C11 and C12 are continuously formed. The memory cell C13 is provided opposite to the memory cell C11 through the memory cell C12. AGs are continuously connected to one another in the direction orthogonal to the above-mentioned one direction of the memory cells. The source and drain regions are connected in parallel with the direction in which the AGs are connected to one another.

Fig. 10 shows schematic structures of the memory cells C12 and C13 in Fig. 9.

Fig. 10 shows a memory cell array according to a second embodiment of the present invention in which a plurality of memory cells are continuously provided, the memory cell having a floating gate 11a provided as a side wall spacer on one of side wall sides of an AG 4.

Fig. 10 shows a non-volatile memory in which memory cells C12 and C13 are continuously connected to one another in one direction, sources 8a of the adjacent memory cells C12 and C13 are commonly provided, and drains 8b of the adjacent memory cells C11 and C12 are commonly provided.

A manufacturing method will be described below.

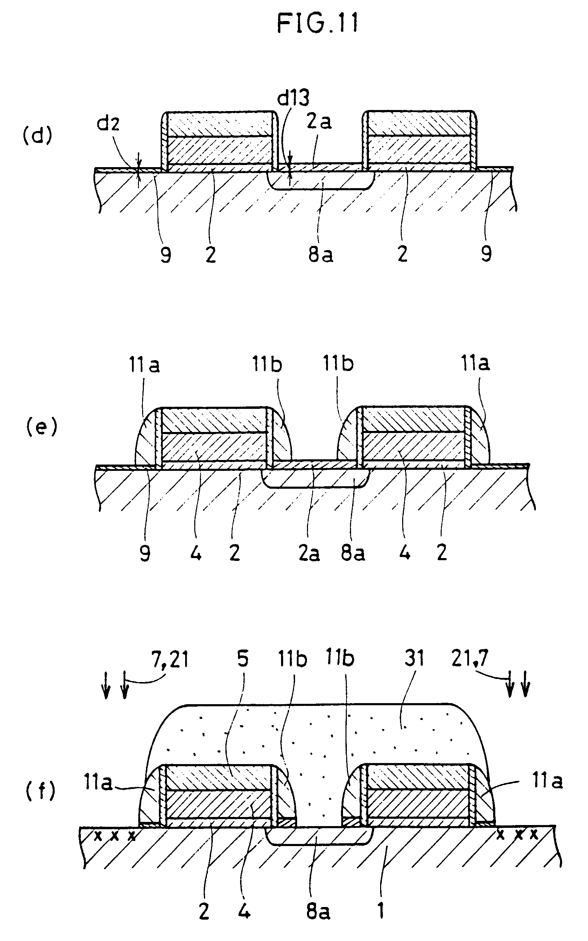

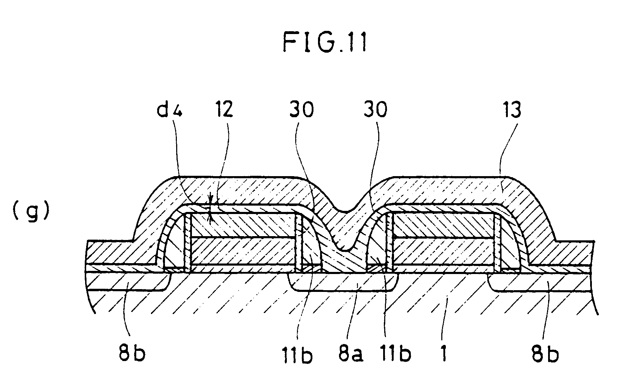

As shown in Fig. 11 (a), a first insulating film 2, an AG 4 and a SiO₂ film 5 are formed on a p-type Si substrate 1 by using a resist pattern 3 [the same step as in Fig. 3 (a)].

As shown in Fig. 11 (b), the resist pattern 3 is removed and a mask 6 is formed. As ions 7 are implanted in a source region.

As shown in Fig. 11 (c), the mask 6 is removed to laminate a SiO₂ film on the whole surface. Then, etchback is carried out to form side wall insulating films 30 [the same step as in Fig. 3 (c)]. In this case, the memory cells C12 and C13 are commonly connected to each other by a source 8a.

As shown in Fig. 11 (d), thermal oxidation is carried out to form a SiO₂ film 9 having a thickness d2 of 80 Å and a SiO₂ film 2a having a thickness d13 of 150 Å. As shown in Fig. 11 (e), a polysilicon layer having a thickness of 4000 Å is laminated on the whole surface. Then, etchback is carried out to form polysilicon side wall spacers 11a and 11b on the side walls of the AG 4. The side wall spacer 11a is used for a floating gate. In this case, the side wall spacer 11b may be removed.

As shown in Fig. 11 (f), As ions 7 and P ions 21 are implanted in a drain region by using a mask 31 and the floating gate 11a.

As shown in Fig. 11 (g), the mask 31 is removed to form a SiO₂ film 12 having a thickness d4 of 200 Å on the whole surface. Then, a polysilicon layer having a thickness of 2000 Å is laminated on the SiO₂ film 12. Thereafter, a control gate 13 is patterned.

In order to operate the memory cell array according to the second embodiment, voltages shown in Table 2 are preferably applied to the memory cell C12.

When voltages shown in Table 2 are applied to the memory cell C12 in the above-mentioned memory cell array, writing, erasing and reading can be executed.

**Table 2**

| | BL2 | BL1 | BL0 | CG1 | CG2 | AG1 | AG2 |
|---|---|---|---|---|---|---|---|
| WRITE | 0 | 5V | 0 | 12V | 0 | 0 | 2V |
| ERASE | 5V | 5V | 0 | -11V | -11V | 0 | 0 |
| READ | 0 | 2V | 0 | 5V | 0 | 0 | 5V |

It is not necessary to form a contact region in the memory cell array according to the first and second embodiments. Consequently, the area of the memory cell array can be reduced. According to the second embodiment, a cell array area can be reduced as compared with the first embodiment for the following reasons.

(1) According to the second embodiment, it is not necessary to form a side wall spacer on a source region 8a between AG 4 and AG 4. Consequently, a width between AG 4 and AG 4 can be reduced.

(2) In the case where the ions 7 are implanted in order to form the source region 8a [Figs. 8 (b) and 11 (b)], a region in which FG is to be formed is at least covered by the resist mask 6. According to the first embodiment, the implantation portion of the source region is defined by the mask 6. Consequently, a mask alignment margin is needed. According to the second embodiment, the FG is not provided on the source region 8a between AG 4 and AG 4. Consequently, the ions 7 can be implanted by using the AG 4 as a mask as shown in Fig. 11 (b). Consequently, the mask alignment margin is not needed so that the width between AG 4 and AG 4 can be reduced. When the voltages are applied to the AG 2 and BL1 of the memory cell C12 [see Figs. 6 and 9] at the time of reading, the voltages are applied to the AG and drain of the memory cell C22. Consequently, an AG transistor of the memory cell C22 is also turned on. If the memory cell C22 is in the state of OVER ERASE, a leak may be caused between BL2 and BL0 in Fig. 6 and between BL1 and S2 in Fig. 9.

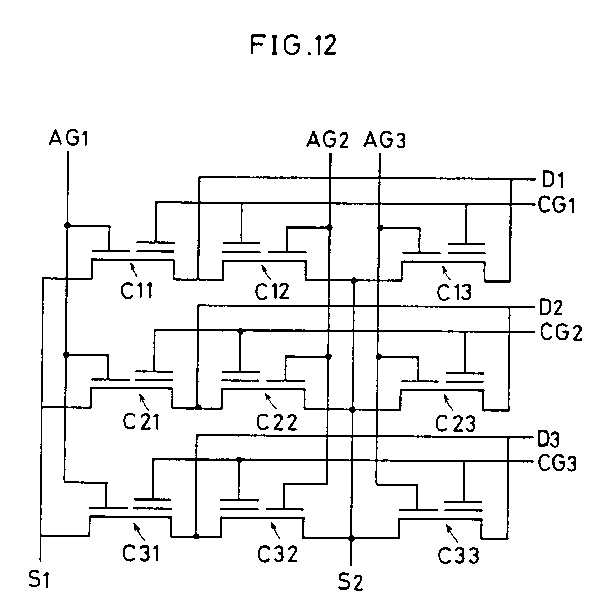

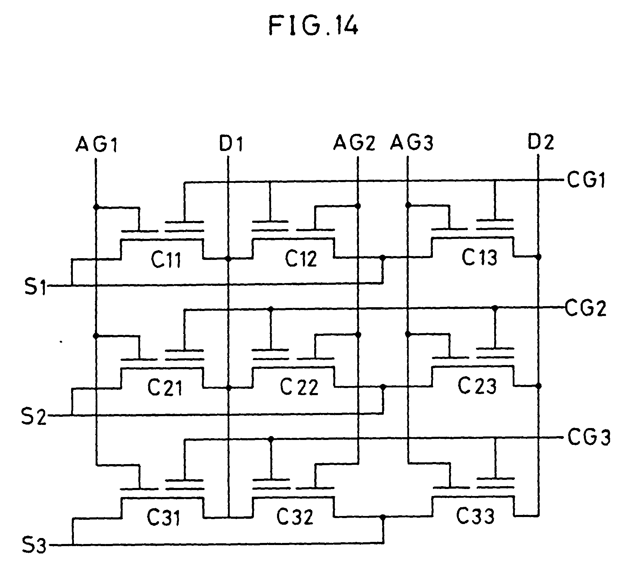

To solve the above-mentioned problem, an AG line and a drain or source line are orthogonal to each other so that a voltage is not simultaneously applied to the AG and drain (source) of a memory cell other than the memory cell executing reading as shown in Figs. 12 and 14. Thus, the leak can be prevented. Fig. 12 shows a memory cell array according to a third embodiment in which a drain line is orthogonal to an AG line. Fig. 14 shows a memory cell array according to a fourth embodiment in which a source line is orthogonal to an AG line.

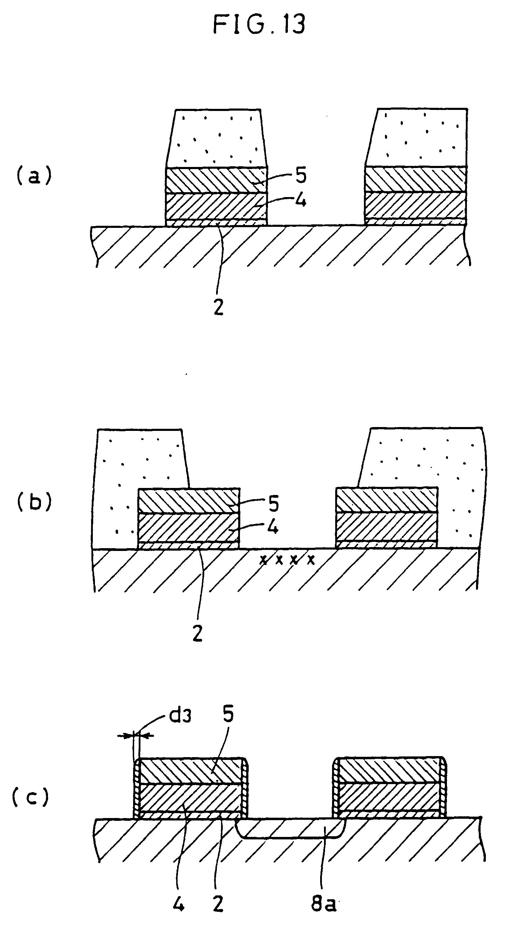

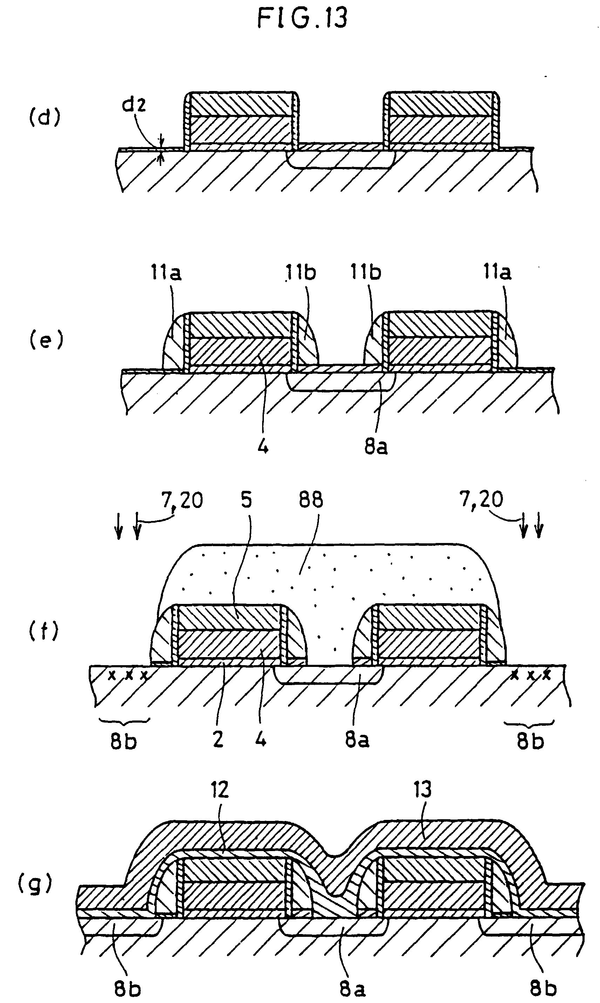

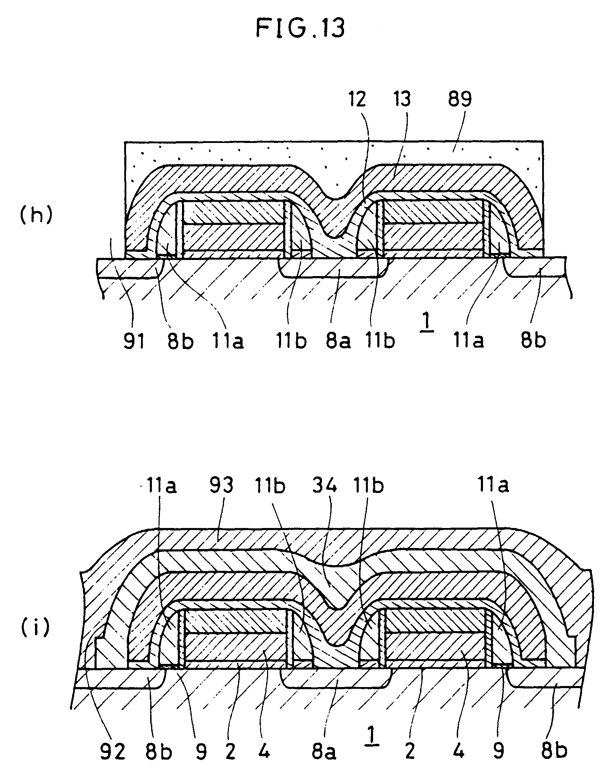

Fig. 13 (i) shows a memory cell array having a drain side contact according to a third embodiment of the present invention. According to the third embodiment, an AG line 4 is orthogonal to a drain line 93 in parallel with the surface of a Si substrate 1.

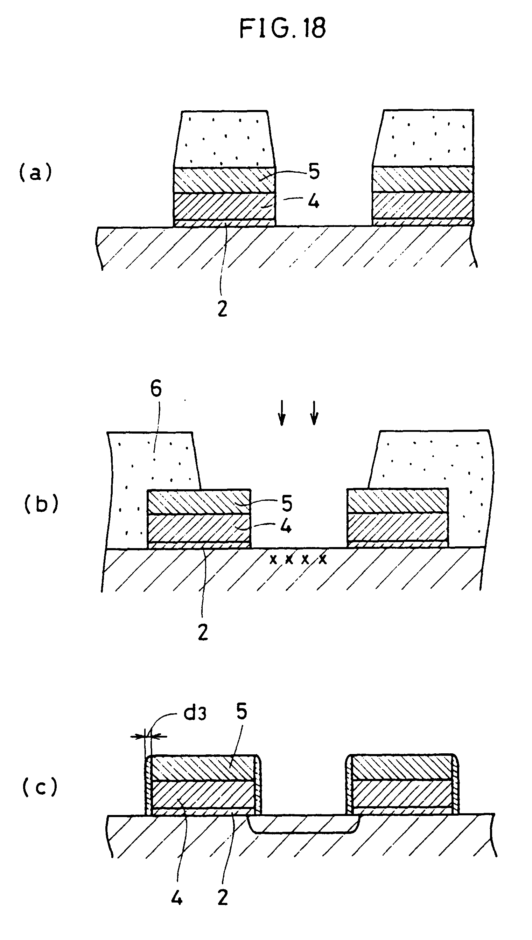

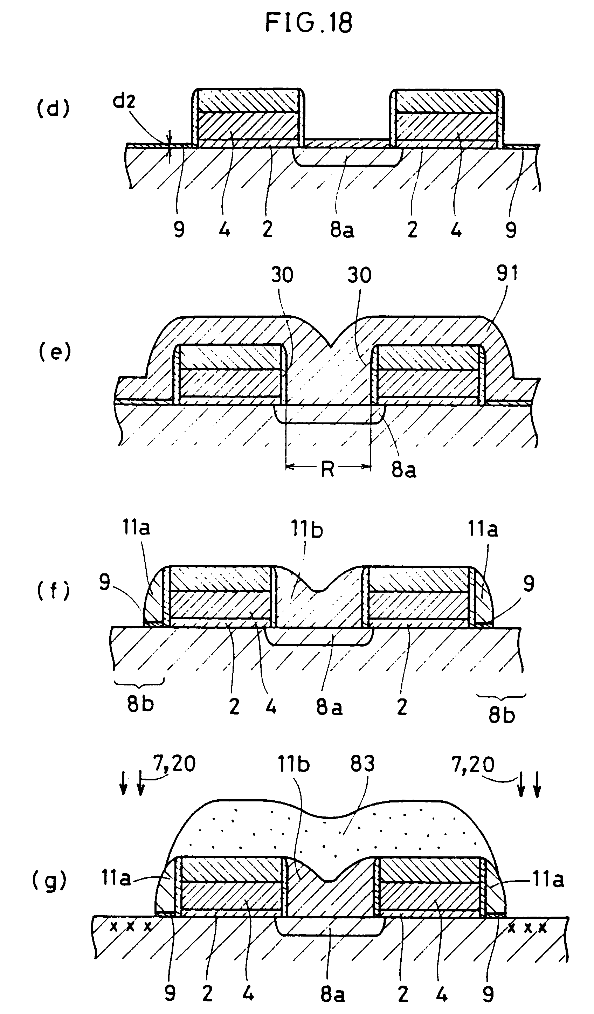

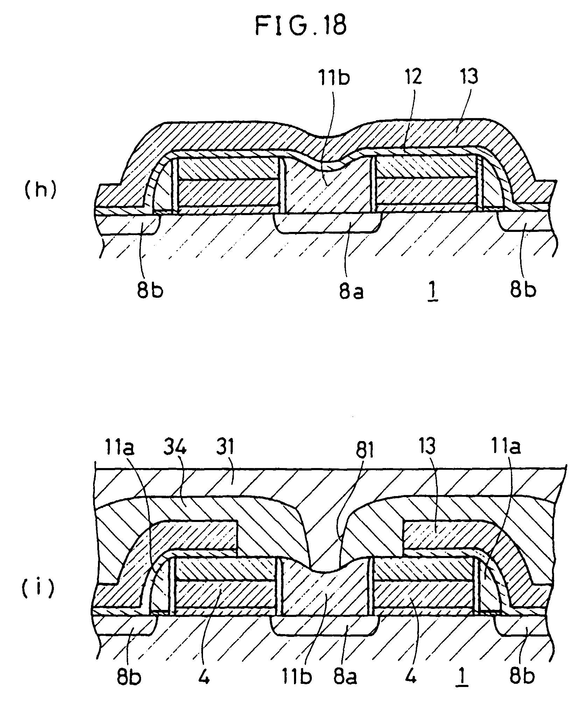

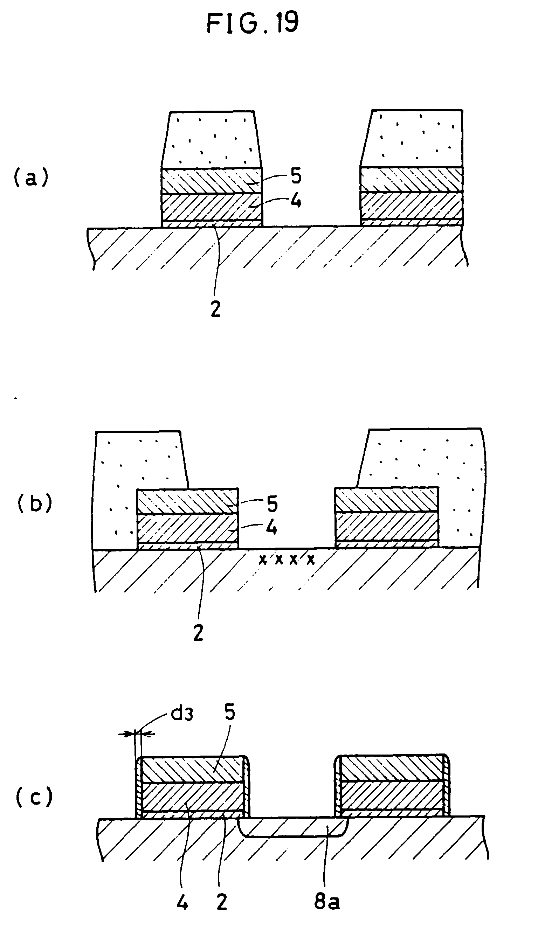

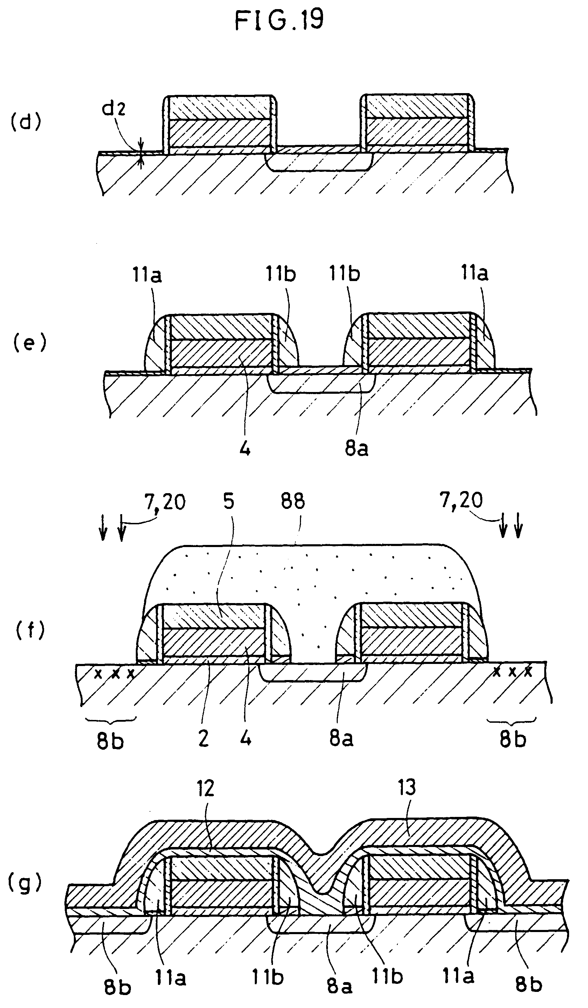

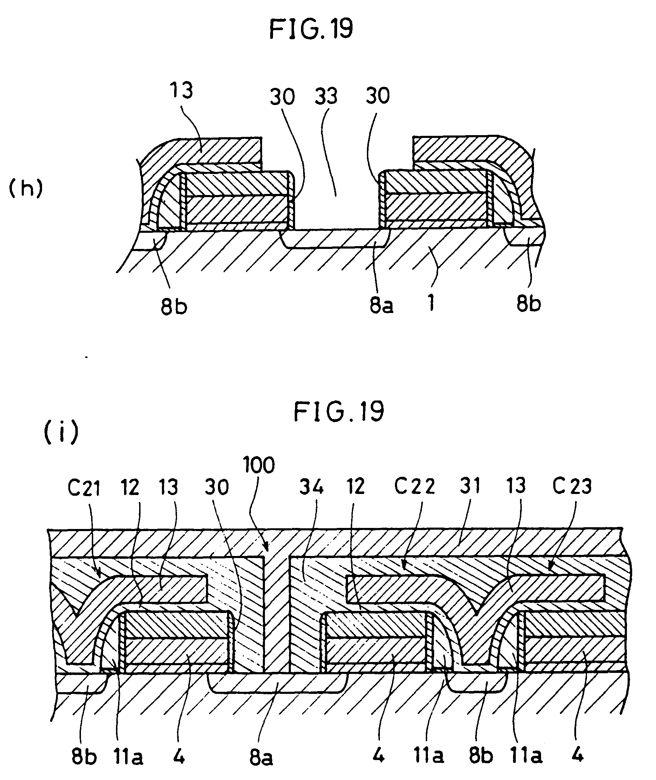

Fig. 19 (i) shows a memory cell array having a source side contact according to a fourth embodiment of the present invention. According to the fourth embodiment, an AG line 4 is orthogonal to a source line 31 in parallel with the surface of a Si substrate 1. In addition, a floating gate 11a is provided as one of side wall spacers of the AG line 4. The floating gate 11a is provided only on the drain 8b side. The side wall spacer 11b is not provided on the source 8a side. The side wall spacer 11b may remain on the source 8a side, which is shown in Fig. 18 (i).

Fig. 18 (i) shows a fifth embodiment of the present invention, in which the side wall spacer 11b is used as a contact pad for connecting the source 8a and the source line 31.

A manufacturing method will be described below.

First, a manufacturing method according to the third embodiment will be described below. Figs. 13 (a) to (i) show the manufacturing method according to the third embodiment.

The steps shown in Figs. 13 (a) to (g) are the same as in Figs. 11 (a) to (g). According to the third embodiment, the side wall spacer 11b may be removed as shown in Fig. 10.

In Fig. 13 (g), a CC 13 is patterned. Then, the CG 13 and a SiO₂ film on the drain region 8b side are removed by using a mask 89. Consequently, a drain side contact 91 is formed [see Fig. 13 (h)]. As shown in Fig. 13 (i), a NSG film having a thickness of 1500 Å and a BPSG film having a thickness of 5000 Å are sequentially laminated to form a layer insulation film 34. Then, the layer insulation film 34 on a drain region 8b is removed by using a mask (not shown) until a Si substrate 1 is exposed. Consequently, an opening 92 is formed.

According to the present embodiment, the AG line 4 is orthogonal to the drain line 93 in parallel with the surface of the Si substrate 1.

As seen from Fig. 12, the AG line 4 is orthogonal to the drain line 93 in parallel with the surface of the Si substrate 1.

Table 4 shows characteristics at the time of writing, erasing and reading. At the time of reading, the drain 8b (D2) of the memory cell C22 is set to 2 V, the AG 2 of the memory cell C22 is set to 5 V, and CG2 of the memory cell C22 is set to 5 V. Consequently, it is possible to eliminate the problem caused in a VIRTUAL GROUND memory cell, i.e., the disadvantage that a leak is caused between BLs when the memory cell is in the state of OVER ERASE.

**Table 4**

| | S1 | S2 | D1 | D2 | D3 | CG1 | CG2 | CG3 | AG1 | AG2 | AG3 |
|---|---|---|---|---|---|---|---|---|---|---|---|
| WRITE | 0 | 0 | 0 | 5V | 0 | 0 | 12V | 0 | 0 | 2V | 0 |
| ERASE | 0 | 0 | 0 | 5V | 5V | -11V | -11V | -11V | 0 | 0 | 0 |
| READ | 0 | 0 | 0 | 2V | 0 | 0 | 5V | 0 | 0 | 5V | 0 |

A manufacturing method according to the fourth embodiment will be described below.

Figs. 19 (a) to (i) show the manufacturing method according to the fourth embodiment.

The steps shown in Figs. 19 (a) to (g) are the same as in Figs. 11 (a) to (g) [Figs. 13 (a) to (g)].

As shown in Fig. 19 (g), a CG 13 is patterned. Then, the CG 13, a SiO₂ film 12 and a side wall 11b on the source region 8a side are removed to form a source side contact 33 [see Fig. 19 (h)]. Thereafter, a NSG film having a thickness of 1500 Å and a BPSG film having a thickness of 5000 Å are sequentially laminated to form a layer insulation film 34 as shown in Fig. 19 (i). The layer insulation film 34 in a source region 8a is removed by using a mask (not shown) until a Si substrate 1 is exposed. Consequently, an opening is formed. Then, a source line 31 is formed. Thus, there can be formed a cell array having a cell in which a polysilicon side wall 11a is provided on the side wall of a first electrode 4.

As seen from Fig. 14, the AG line (AG 1, AG 2 and AG 3) is orthogonal to the source line (S1, S2 and S3) in parallel with the surface of the Si substrate.

Table 3 shows characteristics at the time of writing, erasing and reading. At the time of reading in the memory cell C22, the drain 8b (D1) of the memory cell C22 is set to 2 V, the AG 2 of the memory cell C22 is set to 5 V, and the CC 2 of the memory cell C22 is set to 5 V, and the sources 8a (S1) of the memory cells C11, C12 and C13 are set to 2 V, and the sources 8a (S3) of the memory cells C31, C32 and C33 are set to 2 V.

**Table 3**

| | S1 | S2 | S3 | D1 | D2 | CG1 | CG2 | CG3 | AG1 | AG2 | AG3 |
|---|---|---|---|---|---|---|---|---|---|---|---|
| WRITE | 0 | 0 | 0 | 5V | 0 | 0 | 12V | 0 | 0 | 2V | 0 |
| ERASE | 0 | 0 | 0 | 5V | 5V | -11V | -11V | -11V | 0 | 0 | 0 |
| READ | 2V | 0 | 2V | 2V | 0 | 0 | 5V | 0 | 0 | 5V | 0 |

Finally, a manufacturing method according to the fifth embodiment will be described below.

Figs. 18 (a) to (i) show the manufacturing method according to the fifth embodiment.

The steps shown in Figs. 18 (a) to (d) are the same as in Figs. 11 (a) to (d) [Figs. 19 (a) to (d)].

As shown in Fig. 18 (e), a polysilicon layer 91 having a thickness of 4000 Å is laminated.

Subsequently, etchback is carried out to make side wall spacers 11a and 11b. In this case, if R is not greater than 8000 Å, the side wall spacers 11b on the source region 8a between AG 4 and AG 4 come in contact with each other and the region between AG 4 and AG 4 on the source region 8a is filled with polysilicon. As a result, the pad-like side wall spacer 11b for connecting a source line 31 is formed. The side wall spacers 11b may be provided apart from one another. If R is not smaller than 8000 Å, the side wall spacers 11b are provided apart from one another [see Fig. 18 (f)].

Then, As ions 7 and P ions 20 are implanted in the drain region 8b side by using a mask 83 [see Fig. 18 (g)].

The mask 83 is removed to form a SiO₂ film 12 having a thickness of 200 Å. Then, a polysilicon layer 13 having a thickness of 2000 Å is laminated [see Fig. 18 (h)]. Thereafter, the polysilicon layer 13 and SiO₂ film 12 in a source 8a region are removed by using a mask (not shown).

As shown in Fig. 18 (i), a NSG film having a thickness of 1500 Å and a BPSG film having a thickness of 5000 Å are sequentially laminated to form a layer insulation film 34. The layer insulation film 34 in the source 8a region is removed by using a mask (not shown). Consequently, an opening 81 is formed. Then, a source line 31 is formed [Fig. 18 (i)]. When the opening 81 is formed, the depth of an opening portion can be made small by the side wall spacer 11b.

In the present embodiment, the AG line 4 is orthogonal to the source line 31 in parallel with the surface of a Si substrate 1.

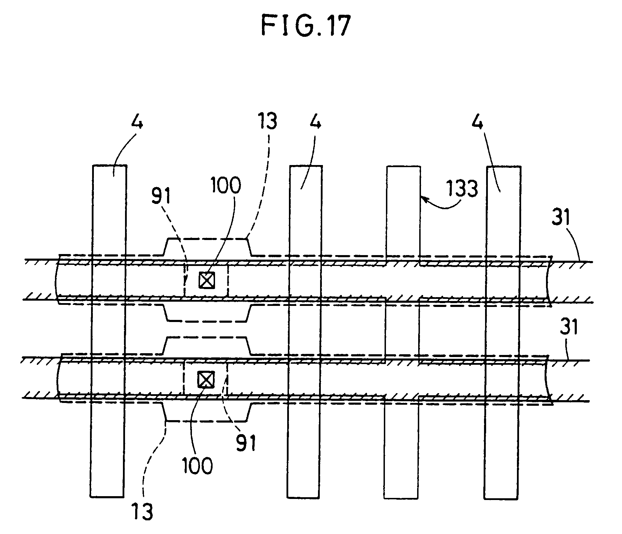

Fig. 17 is a plan view showing the fourth and fifth embodiments. As seen from Fig. 17, the AG line 4 is orthogonal to the source line 31 on a plane basis. According to the third embodiment, an opening 92 is formed on the drain region [see Fig. 13 (i)]. According to the fourth and fifth embodiments, openings 33 and 81 are formed on the CG of the source region [see Figs. 18 (i) and 19 (h)]. The source line 31 is formed which is connected to the source region through a source side contact 100 [see Figs. 18 (i) and 19 (i)].

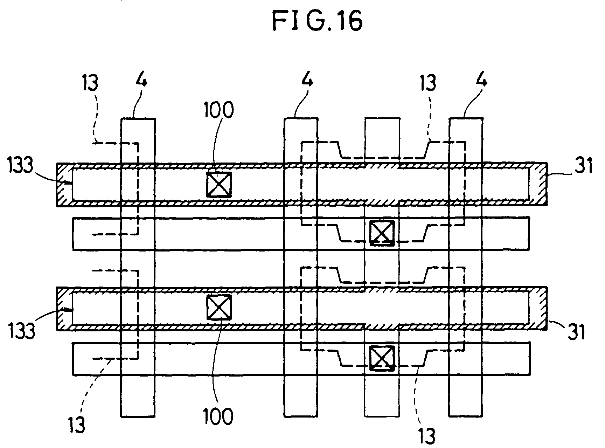

Fig. 16 shows the fourth and fifth embodiments. In Fig. 16, the CG 13 is patterned to cover at least the floating gate 11a and the drain region. The source line 31 is connected to the source region through the contact 100 on the source region. In Figs. 16 and 17, the reference numeral 133 denotes an active region.

According to the present invention, a side wall polysilicon electrode on the side wall of an auxiliary gate is used as a floating gate for a source-side injection type FLASH EEPROM. Consequently, it is possible to obtain a non-volatile memory in which a writing efficiency is enhanced so that writing can be performed at a single supply voltage of 5 V or less and at a speed of 1 µs or less, whereby a single power source is sufficient. The area of the memory cell can be reduced. In addition, an on-chip high voltage generation circuit can easily be designed due to a low programming current around 10 µA.

## Claims

1. A non-volatile memory having a memory cell, the memory cell comprising:
a semiconductor substrate (1) having first and second impurity diffusion layers (8a, 8b);
a first insulating film (2) provided on the semiconductor substrate between the first and second impurity diffusion layers and on the first impurity diffusion layer side;
a first electrode (4) formed on the first insulating film, and self-aligned with the first impurity diffusion layer (8a); and
a second electrode (13);
characterized by:
a tunnel dielectric film (9) extended from the first insulating film (2) to the second impurity diffusion layer region which is provided opposite the first impurity diffusion layer side;
a floating gate (lla) formed on the tunnel dielectric film as a side wall spacer on the side wall of the first electrode (4) through an insulating film (30), and self-aligned with the second impurity diffusion layer (8b); and
said second electrode (13) being provided at least on the floating gate through a second insulating film (12) so as to control the potential of the floating gate;
whereby channel hot electrons can be injected from the inversion layer formed under the first electrode (4), which is controlled by the first electrode, to the floating gate (11a).

2. A non-volatile memory according to claim 1, wherein the second electrode (13) is provided through the second insulating film (12) on the second impurity diffusion layer (8b), floating gate (11a), first electrode (4) and first impurity diffusion layer (8a).

3. A non-volatile memory according to claim 1, wherein a plurality of said memory cells are continuously provided in one direction, and the first and second impurity diffusion layers of memory cells (C11, C12) adjacent in said one direction are continuously formed.

4. A non-volatile memory according to claim 3, wherein a plurality of said memory cells are provided in another direction orthogonal to said one direction, and the impurity diffusion layers of memory cells (C11, C21) adjacent in said other direction are connected to one another by embedded diffusion layers.

5. A non-volatile memory according to claim 3, wherein the second electrodes (13) are extended through the second insulating films (12) to the second impurity diffusion layers (8b), floating gates (11a), first electrodes (4) and first impurity diffusion layers (8a) of the adjacent memory cells.

6. A non-volatile memory according to claim 4, wherein the first electrodes (4) of memory cells adjacent in said other direction are continuously provided adjacently to each other.

7. A non-volatile memory according to claim 1, wherein a plurality of said memory cells are continuously provided in one direction, three adjacent memory cells (C11, C12, C13) are treated as a unit, the first impurity diffusion layers of one pair of adjacent memory cells (C11, C12) are commonly provided, and the second impurity diffusion layers of the other pair of adjacent memory cells (C12, C13) are commonly provided.

8. A non-volatile memory according to claim 7, wherein the first electrode (4) has a floating gate provided as one of side wall spacers (11a) on the second impurity diffusion layer (8b) side and also has another side wall spacer (11b) provided on the first impurity diffusion layer (8a) side, the other side wall spacer (11b) being formed simultaneously with the floating gate (11a), and the other side wall spacer (11b) and the first impurity diffusion layer (8a) being connected to each other.

9. A non-volatile memory according to claim 7, wherein a plurality of said memory cells are provided in another direction orthogonal to said one direction, and the impurity diffusion layers of memory cells (C11, C21; C12, C22; C13, C23) adjacent in said other direction are connected to one another by embedded diffusion layers.

10. A non-volatile memory according to claim 7, wherein the first impurity diffusion layers (8a) of memory cells (C21, C22) adjacent in said one direction are commonly provided, a first wiring (31) is pulled out of the first impurity diffusion layer, and the first electrodes (4) of the memory cells are provided adjacently to each other through the pull-out first wiring (31).

11. A non-volatile memory according to claim 9, wherein the second impurity diffusion layers (8b) of memory cells (C22, C23) adjacent in said one direction are commonly provided, and the floating gates (lla) of the memory cells are provided adjacently to each other and extend continuously in said other direction.

12. A non-volatile memory according to claim 7, wherein the floating gate is provided as a side wall (11a) on the side wall side of the first electrode (4), the second impurity diffusion layers (8b) of memory cells adjacent in said one direction are commonly provided, a second wiring (93) is pulled out of the second impurity diffusion layer (8b), and the floating gates (11a) of the memory cells are provided adjacently to each other through the pull-out second wiring (93).

13. A non-volatile memory according to claim 9, wherein the floating gate is provided as a side wall (11a) on the side wall side of the first electrode (4), the first impurity diffusion layers (8a) of memory cells adjacent in said one direction are commonly provided, and the first electrodes (4) of the memory cells are provided adjacently to each other and extend continuously in said other direction.

14. A non-volatile memory according to claim 1, wherein a plurality of said memory cells are arranged in a matrix, the memory cells are arranged in the matrix in the direction of Y and have first electrodes (4) connected to one another in the direction Y, the memory cells are arranged in the matrix in the direction of X and have the adjacent first impurity diffusion layers (8a) commonly formed and the adjacent second impurity diffusion layers (8b) continuously formed, and one of the first and second impurity diffusion layers is connected in the direction of X, and the other impurity diffusion layer is connected in the direction of Y.

15. A non-volatile memory according to claim 14, wherein the first electrode (4) has a floating gate provided as one side wall spacer (11a) on the second impurity diffusion layer (8b) side and also has another side wall spacer (11b) provided on the first impurity diffusion layer (8a) side, the other side wall spacer (11b) being formed simultaneously with the floating gate (11a), and the other side wall spacer (11b) and the first impurity diffusion layer (8a) are connected to each other.

16. A non-volatile memory according to claim 14, wherein first wirings (D1; D2; D3) are pulled out of the second impurity diffusion layers (8b) of the memory cells which are continuously provided in the direction of X, said first wirings being connected to one another in the direction of X, and the first impurity diffusion layers (8a) of the memory cells which are continuously provided in the direction of Y, are connected to one another through embedded diffusion layers in the direction of Y.

## Patentansprüche

1. Nichtflüchtiger Speicher mit einer Speicherzelle, die folgendes aufweist:
- ein Halbleitersubstrat (1) mit einer ersten und einer zweiten Fremdstoffdiffusionsschicht (8a, 8b);
- einen ersten Isolierfilm (2), der auf dem Halbleitersubstrat zwischen der ersten und zweiten Fremdstoffdiffusionsschicht und auf der Seite der ersten Fremdstoffdiffusionsschicht vorhanden ist;
- eine erste Elektrode (4), die auf dem ersten Isolierfilm ausgebildet ist und mit der ersten Fremdstoffdiffusionsschicht (8a) selbstausgerichtet ist; und
- eine zweite Elektrode (13);
**gekennzeichnet durch:**
- einen dielektrischen Tunnelfilm (9), der sich vom ersten Isolierfilm (2) zum zweiten Fremdstoffdiffusions-Schichtbereich erstreckt, der der Seite der ersten Fremdstoffdiffusionsschicht gegenüberstehend vorhanden ist;
- ein potentialungebundenes Gate (11a), das auf dem dielektrischen Tunnelfilm als Seitenwand-Abstandshalter an der Seitenwand der ersten Elektrode (4) über einem Isolierfilm (30) ausgebildet ist und mit der zweiten Fremdstoffdiffusionsschicht (8b) selbstausgerichtet ist;
- wobei die zweite Elektrode (13) über einem zweiten Isolierfilm (12) zumindest auf dem potentialungebundenen Gate vorhanden ist, um das Potential desselben zu steuern;
- wodurch heiße Kanalelektronen von der Inversionsschicht, die unter der ersten Elektrode (4) ausgebildet ist und von dieser gesteuert wird, in das potentialungebundene Gate (11a) injiziert werden.

2. Nichtflüchtiger Speicher nach Anspruch 1, bei dem die zweite Elektrode (13) durch den zweiten Isolierfilm (12) auf der zweiten Fremdstoffdiffusionsschicht (8b), dem potentialungebundenen Gate (11a), der ersten Elektrode (4) und der ersten Fremdstoffdiffusionsschicht (8a) vorhanden ist.

3. Nichtflüchtiger Speicher nach Anspruch 1, bei dem eine Vielzahl derartiger Speicherzellen kontinuierlich in einer Richtung vorhanden sind und die erste und zweite Fremdstoffdiffusionsschicht von Speicherzellen (C11, C12), die in der einen Richtung einander benachbart sind, kontinuierlich ausgebildet sind.

4. Nichtflüchtiger Speicher nach Anspruch 3, bei dem eine Vielzahl der Speicherzellen in einer anderen Richtung angeordnet ist, die rechtwinklig zur einen Richtung verläuft, und bei dem Fremdstoffdiffusionsschichten von Speicherzellen (C11, C21), die einander in der anderen Richtung benachbart sind, durch eingebettete Diffusionsschichten miteinander verbunden sind.

5. Nichtflüchtiger Speicher nach Anspruch 3, bei dem sich die zweiten Elektroden (13) durch die zweiten Isolierfilme (12) zu den zweiten Fremdstoffdiffusionsschichten (8b), den potentialungebundenen Gates (11a), den ersten Elektroden (4) und den ersten Fremdstoffdiffusionsschichten (8a) der benachbarten Speicherzellen erstrecken.

6. Nichtflüchtiger Speicher nach Anspruch 4, bei dem die ersten Elektroden (4) der in der anderen Richtung benachbarten Speicherzellen kontinuierlich benachbart zueinander vorhanden sind.

7. Nichtflüchtiger Speicher nach Anspruch 1, bei dem eine Vielzahl von Speicherzellen kontinuierlich in einer Richtung vorhanden ist, wobei drei benachbarte Speicherzellen (C11, C12, C13) als eine Einheit behandelt werden, die ersten Fremdstoffdiffusionsschichten eines Paars benachbarter Speicherzellen (C11, C12) gemeinsam vorhanden sind und die zweiten Fremdstoffdiffusionsschichten des anderen Paars benachbarter Speicherzellen (C12, C13) gemeinsam vorhanden sind.

8. Nichtflüchtiger Speicher nach Anspruch 7, bei dem die erste Elektrode (4) ein potentialungebundenes Gate aufweist, das als einer der Seitenwand-Abstandshalter (11a) auf der Seite der zweiten Fremdstoffdiffusionsschicht (8b) vorhanden ist, und auch einen anderen Seitenwand-Abstandshalter (11b) aufweist, der auf der Seite der ersten Fremdstoffdiffusionsschicht (8a) vorhanden ist, wobei der andere Seitenwand-Abstandshalter (11b) gleichzeitig mit dem potentialungebundenen Gate (11a) hergestellt wird und wobei der andere Seitenwand-Abstandshalter (11b) und die erste Fremdstoffdiffusionsschicht (8a) miteinander verbunden sind.

9. Nichtflüchtiger Speicher nach Anspruch 7, bei dem eine Vielzahl von Speicherzellen in einer anderen Richtung rechtwinklig zur einen Richtung angeordnet ist und die Fremdstoffdiffusionsschicht von Speicherzellen (C11, C21; C12, C22; C13, C23) in der anderen Richtung einander benachbart sind, durch eingebettete Diffusionsschichten miteinander verbunden sind.

10. Nichtflüchtiger Speicher nach Anspruch 7, bei dem die ersten Fremdstoffdiffusionsschichten (8a) von Speicherzellen (C21, C22), die in der einen Richtung einander benachbart sind, gemeinsam vorhanden sind, eine erste Leiterbahn (31) aus der ersten Fremdstoffdiffusionsschicht herausgezogen ist und die ersten Elektroden (4) der Speicherzellen durch die herausgezogene erste Leiterbahn (31) benachbart zueinander angeordnet sind.

11. Nichtflüchtiger Speicher nach Anspruch 9, bei dem die zweiten Fremdstoffdiffusionsschichten (8b) von Speicherzellen (C22, C23), die in der einen Richtung benachbart sind, gemeinsam vorhanden sind, und die potentialungebundenen Gates (11a) der Speicherzellen benachbart zueinander vorhanden sind und sich kontinuierlich in der anderen Richtung erstrecken.

12. Nichtflüchtiger Speicher nach Anspruch 7, bei dem das potentialungebundene Gate als Seitenwand (11a) an der Seitenwand der ersten Elektrode (4) vorhanden ist, die zweiten Fremdstoffdiffusionsschichten (8b) der in der einen Richtung benachbarten Speicherzellen gemeinsam vorhanden sind, eine zweite Leiterbahn (93) aus der zweiten Fremdstoffdiffusionsschicht (8b) herausgezogen ist und die potentialungebundenen Gates (11a) der Speicherzellen durch die herausgezogene zweite Leiterbahn (93) benachbart zueinander vorhanden sind.

13. Nichtflüchtiger Speicher nach Anspruch 9, bei dem das potentialungebundene Gate als Seitenwand (11a) an der Seitenwand der ersten Elektrode (4) vorhanden ist, die ersten Fremdstoffdiffusionsschichten (8a) der Speicherzellen, die in der einen Richtung benachbart sind, gemeinsam vorhanden sind, und die ersten Elektroden (4) der Speicherzellen benachbart zueinander vorhanden sind und sich kontinuierlich in der anderen Richtung erstrecken.

14. Nichtflüchtiger Speicher nach Anspruch 1, bei dem eine Vielzahl der Speicherzellen in einer Matrix angeordnet ist, wobei die Speicherzellen in der Matrix in der Y-Richtung angeordnet sind und erste Elektroden (4) aufweisen, die in der Y-Richtung miteinander verbunden sind, die Speicherzellen in der Matrix in der X-Richtung angeordnet sind und benachbarte erste Fremdstoffdiffusionsschichten (8a), die gemeinsam ausgebildet sind, und benachbarte zweite Fremdstoffdiffusionsschichten (8b) aufweisen, die kontinuierlich ausgebildet sind, und wobei von der ersten und zweiten Fremdstoffdiffusionsschicht die eine in der X-Richtung angeschlossen ist und die andere Fremdstoffdiffusionsschicht in der Y-Richtung angeschlossen ist.

15. Nichtflüchtiger Speicher nach Anspruch 14, bei dem die erste Elektrode (4) ein potentialungebundenes Gate aufweist, das als ein Seitenwand-Abstandshalter (11a) auf der Seite der zweiten Fremdstoffdiffusionsschicht (8b) vorhanden ist, und sie auch einen anderen Seitenwand-Abstandshalter (11b) aufweist, der auf der Seite der ersten Fremdstoffdiffusionsschicht (8a) vorhanden ist, wobei der andere Seitenwand-Abstandshalter (11b) gleichzeitig mit dem potentialungebundenen Gate (11a) hergestellt wurde, und wobei der andere Seitenwand-Abstandshalter (11b) und die erste Fremdstoffdiffusionsschicht (8a) miteinander verbunden sind.

16. Nichtflüchtiger Speicher nach Anspruch 14, bei dem erste Leiterbahnen (D1; D2; D3) aus den zweiten Fremdstoffdiffusionsschichten (8b) derjenigen Speicherzellen herausgezogen sind, die in der X-Richtung kontinuierlich vorhanden sind, wobei die ersten Leiterbahnen in der X-Richtung miteinander verbunden sind, und die ersten Fremdstoffdiffusionsschichten (8a) derjenigen Speicherzellen, die kontinuierlich in der Y-Richtung vorhanden sind, durch eingebettete Diffusionsschichten in der Y-Richtung miteinander verbunden sind.

## Revendications

1. Mémoire non volatile ayant une cellule de mémoire, la cellule de mémoire comprenant:
un substrat semi-conducteur (1) ayant des première et seconde couches de diffusion d'impuretés (8a, 8b);
un premier film isolant (2) prévu sur le substrat semi-conducteur entre les première et seconde couches de diffusion d'impuretés et sur le côté de la première couche de diffusion d'impuretés;
une première électrode (4) formée sur le premier film isolant, et auto-alignée avec la première couche de diffusion d'impuretés (8a); et
une seconde électrode (13);
caractérisée par:
un film diélectrique de tunnel (9), s'étendant depuis le premier film d'isolation (2) jusqu'à la seconde région de couche de diffusion d'impuretés, qui est prévu face au côté de la première couche de diffusion d'impuretés;
une grille flottante (11a) qui est formée sur le film diélectrique de tunnel comme un élément d'espacement de paroi latérale sur la paroi latérale de la première électrode (4), à travers un film isolant (30), et auto-alignée avec la seconde couche de diffusion d'impuretés (8b); et
ladite seconde électrode (13) qui est prévue au moins sur la grille flottante à travers un second film isolant (12) de manière à commander le potentiel de la grille flottante;
de sorte que des électrons chauds de canal peuvent être injectés depuis la couche d'inversion formée sous la première électrode (4), qui est commandée par la première électrode, vers la grille flottante (11a).

2. Mémoire non volatile selon la revendication 1, dans laquelle la seconde électrode (13) est prévue, à travers le second film isolant (12), sur la seconde couche de diffusion d'impuretés (8b), la grille flottante (11a), la première électrode (4) et la première couche de diffusion d'impuretés (8a).

3. Mémoire non volatile selon la revendication 1, dans laquelle une pluralité desdites cellules de mémoire sont prévues de manière continue dans une première direction, et les premières et secondes couches de diffusion d'impuretés de cellules de mémoire (C11, C12) adjacentes dans ladite première direction sont formées de manière continue.

4. Mémoire non volatile selon la revendication 3, dans laquelle une pluralité desdites cellules de mémoire sont prévues dans une autre direction orthogonale à ladite première direction, et les couches de diffusion d'impuretés de cellules de mémoire (C11, C21) adjacentes dans ladite autre direction sont reliées entre elles par des couches de diffusion enterrées.

5. Mémoire non volatile selon la revendication 3, dans laquelle les secondes électrodes (13) s'étendent à travers les seconds films isolants (12) jusqu'aux secondes couches de diffusion d'impuretés (8b), aux grilles flottantes (11a), aux premières électrodes (4) et aux premières couches de diffusion d'impuretés (8a) des cellules de mémoire adjacentes.

6. Mémoire non volatile selon la revendication 4, dans laquelle les premières électrodes (4) de cellules de mémoire adjacentes dans ladite autre direction sont prévues adjacentes de manière continue les unes avec les autres.

7. Mémoire non volatile selon la revendication 1, dans laquelle une pluralité desdites cellules de mémoire sont prévues de manière continue dans une première direction, trois cellules de mémoire adjacentes (C11, C12, C13) sont traitées comme une unité, les premières couches de diffusion d'impuretés d'une première paire de cellules de mémoire adjacentes (C11, C12) sont prévues de manière commune, et les secondes couches de diffusion d'impuretés de l'autre paire de cellules de mémoire adjacentes (C12, C13) sont prévues de manière commune.

8. Mémoire non volatile selon la revendication 7, dans laquelle la première électrode (4) possède une grille flottante prévue comme l'un des éléments d'espacement de paroi latérale (11a) sur le côté de la seconde couche de diffusion d'impuretés (8b) et possède aussi un autre élément d'espacement de paroi latérale (11b) prévu sur le côté de la première couche de diffusion d'impuretés (8a), l'autre élément d'espacement de paroi latérale (11b) étant formé simultanément avec la grille flottante (11a), et l'autre élément d'espacement de paroi latérale (11b) et la première couche de diffusion d'impuretés (8a) étant reliés l'un à l'autre.

9. Mémoire non volatile selon la revendication 7, dans laquelle une pluralité desdites cellules de mémoire sont prévues dans une autre direction orthogonale à ladite première direction, et les couches de diffusion d'impuretés de cellules de mémoire (C11, C21; C12, C22; C13, C23) adjacentes dans ladite autre direction sont reliées entre elles par des couches de diffusion enterrées.

10. Mémoire non volatile selon la revendication 7, dans laquelle les premières couches de diffusion d'impuretés (8a) de cellules de mémoire (C21, C22) adjacentes dans ladite première direction sont prévues de manière commune, un premier câblage (31) est tiré hors de la première couche de diffusion d'impuretés, et les premières électrodes (4) des cellules de mémoire sont prévues de manière adjacente l'une à l'autre à travers le premier câblage tiré (31).

11. Mémoire non volatile selon la revendication 9, dans laquelle les secondes couches de diffusion d'impuretés (8b) de cellules de mémoire (C22, C23) adjacentes dans ladite première direction sont prévues de manière commune, et les grilles flottantes (11a) des cellules de mémoire sont prévues de manière adjacente l'une à l'autre et s'étendent de manière continue dans ladite autre direction.

12. Mémoire non volatile selon la revendication 7, dans laquelle la grille flottante est prévue comme une paroi latérale (11a) sur le côté de paroi latérale de la première électrode (4), les secondes couches de diffusion d'impuretés (8b) de cellules de mémoire adjacentes dans ladite première direction sont prévues de manière commune, un second câblage (93) est tiré hors de la seconde couche de diffusion d'impuretés (8b), et les grilles flottantes (11a) des cellules de mémoire sont prévues de manière adjacente l'une à l'autre à travers le second câblage tiré (93).

13. Mémoire non volatile selon la revendication 9, dans laquelle la grille flottante est prévue comme une paroi latérale (11a) sur le côté de paroi latérale de la première électrode (4), les premières couches de diffusion d'impuretés (8a) de cellules de mémoire adjacentes dans ladite première direction sont prévues de manière commune, et les premières électrodes (4) des cellules de mémoire sont prévues adjacentes l'une à l'autre et s'étendent de manière continue dans ladite autre direction.

14. Mémoire non volatile selon la revendication 1, dans laquelle une pluralité desdites cellules de mémoire sont disposées selon une matrice, les cellules de mémoire sont disposées selon la matrice dans la direction Y et ont des premières électrodes (4) connectées entre elles dans la direction Y, les cellules de mémoire sont disposées selon la matrice dans la direction X et ont les premières couches de diffusion d'impuretés adjacentes (8a) formées de manière commune et les secondes couches de diffusion d'impuretés adjacentes (8b) formées de manière continue, et l'une des première et seconde couches de diffusion d'impuretés est connectée dans la direction X, et l'autre couche de diffusion d'impuretés est connectée dans la direction Y.

15. Mémoire non volatile selon la revendication 14, dans laquelle la première électrode (4) possède une grille flottante prévue comme un élément d'espacement de paroi latérale (11a) sur le côté de la seconde couche de diffusion d'impuretés (8b) et possède aussi un autre élément d'espacement de paroi latérale (11b) prévu sur le côté de la première couche de diffusion d'impuretés (8a), l'autre élément d'espacement de paroi latérale (11b) étant formé simultanément avec la grille flottante (11a), et l'autre élément d'espacement de paroi latérale (11b) et la première couche de diffusion d'impuretés (8a) sont reliés l'un à l'autre.

16. Mémoire non volatile selon la revendication 14, dans laquelle des premiers câblages (D1; D2; D3) sont tirés hors des secondes couches de diffusion d'impuretés (8b) des cellules de mémoire qui sont prévues de manière continue dans la direction X, lesdits premiers câblages étant connectés entre eux dans la direction X, et les premières couches de diffusion d'impuretés (8a) des cellules de mémoire, qui sont prévues de manière continue dans la direction Y, sont reliées entre elles à travers des couches de diffusion enterrées dans la direction Y.
